# EUROPÄISCHE PATENTSCHRIFT

(11) **EP 0 578 021 B1**
(45) Veröffentlichungstag und Bekanntmachung des Hinweises auf die Patenterteilung: **10.05.2000**
(21) Anmeldenummer: 93109639.0
(22) Anmeldetag: 16.06.1993
(51) Int. Cl.: H04R 25/00, H03K 4/06

(54) **Hörgerät**
Hearing aid
Prothèse auditive

(30) Priorität: 29.06.1992 DE 4221303
(43) Veröffentlichungstag der Anmeldung: 12.01.1994
(73) Patentinhaber: Siemens Audiologische Technik GmbH, 91058 Erlangen (DE)
(72) Erfinder: Martin, Raimund, Dipl.-Ing., D-8557 Eggolsheim (DE); Pfannenmüller, Gerhard, D-8507 Oberasbach (DE)
(74) Vertreter: Zedlitz, Peter

(56) Entgegenhaltungen:
- DE-A- 3 345 921
- DE-A- 3 616 752
- DE-B- 2 716 336
- FR-A- 2 646 031
- IEEE JOURNAL OF SOLID-STATE CIRCUITS, Bd. 24, Nr. 2, April 1989 Seiten 301-312, XP 000124886 CALLIAS F ET AL 'A SET OF FOUR IC'S IN CMOS TECHNOLOGY FOR A PROGRAMMABLE HEARING AID'

## Beschreibung

Die Erfindung bezieht sich auf ein Hörgerät mit einem Eingangswandler, einer eine Endstufe aufweisenden Nutzsignalbearbeitungseinrichtung und mit einem Ausgangswandler, wobei vor der Endstufe eine zeitdiskrete Nutzsignalbearbeitung vorgesehen ist, die durch ein Abtastsignal gesteuert ist.

Aus der DE-AS 27 16 336 ist ein Hörgerät der eingangs genannten Art bekannt. Vor einer Endstufe und nach einem Eingangswandler (Mikrofon) sind ein Analog-Digital-Wandler und ein Digital-Analog-Wandler angeordnet. Für die zeitdiskrete Signalbearbeitung ist des weiteren eine Abtastfrequenz vorgesehen. Die Abtastfrequenz ist nicht geringer gewählt als das Doppelte der oberen Grenzfrequenz der zu bearbeitenden Nutzsignale.

Aus der DE-PS 36 16 752 ist ein Hörgerät bekannt, bei dem in der Endstufe eine zeitdiskrete Nutzsignalbearbeitung mit einer Pulsdauermodulation vorgesehen ist, die mit Hilfe eines Dreiecksignals gebildet ist. Das Dreiecksignal wird über einen Integrator gewonnen, der von einem Rechtecksignal aus einem Rechteckgenerator angesteuert wird. Die Frequenz des Rechtecksignals und damit auch die Frequenz des Dreiecksignals liegen im Ultraschallfrequenzbereich. Solange die Oszillatorfrequenz zumindest das Zweifache der Frequenz der höchsten Tonfrequenzkomponente ist, besitzt das sich ergebende Frequenzspektrum einen Tonfrequenzteil, der ein Abbild der Spannung darstellt, die von einem Mikrofon erzeugt wird, wie auch Ultraschallfrequenzkomponenten, die von der Schaltwirkung abgeleitet werden, die durch einen Oszillator induziert wird. Die Endstufe ist als Schaltverstärker ausgebildet.

Aus dem Buch: Halbleiterschaltungstechnik, 6. Auflage, Tietze und Schenk, Springer-Verlag, Berlin u.a., 1983, Seite 462, ist ein Oszillator bekannt, der als Dreieckspannungsgenerator ausgebildet ist, wobei dessen Dreiecksignal in einem dem Oszillator zugeordneten Schmitt-Trigger mit einer oberen und unteren Schwellenspannung vergleichbar ist. Im Falle der Übereinstimmung des Dreiecksignals mit einer der Schwellenspannungen gibt der Schmitt-Trigger ein Signal an einen Analogschalter ab. Der Oszillator weist einen Integrator auf, dessen Integrationsrichtung in Abhängigkeit von einem über den Analogschalter gelieferten Eingangssignal umkehrbar ist. Der Integrator steht ausgangsseitig mit dem Schmitt-Trigger in Wirkverbindung, wobei der Schmitt-Trigger den Analogschalter steuert, durch welchen dem Integrator das Eingangssignal zur Umkehr der Integrationsrichtung an seinem Integratorausgang zuführbar ist.

Mit der Erfindung wurde erkannt, daß einerseits eine Kombination von verschiedenen zeitdiskreten Nutzsignalbearbeitungsverfahren in nur einem Hörgerät vorteilhaft sein kann und daß andererseits der erforderliche Aufwand für die Erzeugung der unterschiedlichen Hilfssignale (z.B. Abtastsignal und Dreiecksignal) relativ groß ist und schon von vornherein zu Platzproblemen in dem relativ kleinen Hörgerät führt.

Des weiteren wurde gefunden, daß die beiden mindestens erforderlichen Hilfssignale störende Beeinflussungen in den beiden verschiedenen zeitdiskreten Nutzsignalbearbeitungsverfahren hervorrufen können. Insbesondere entstehen durch die Hilfssignale aufgrund von Intermodulation zusätzliche Frequenzen, die unmittelbar oder durch Mischung in den zu bearbeitenden Frequenzbereich der Nutzsignale fallen können. Eine gegenseitige Abschirmung und/ oder Entkopplung, z.B. durch Filter, der relevanten Komponenten für die verschiedenen zeitdiskreten Nutzsignalaufbereitungsverfahren wurde sowohl den schaltungstechnischen Aufwand als auch den Platzbedarf in dem Hörgerät nochmals deutlich vergrößern. Soweit derartige Hörgeräte realisiert werden, müssen die sonach entstehenden Nachteile in Kauf genommen werden.

Der Erfindung liegt die Aufgabe zugrunde, ein Hörgerät der eingangs genannten Art so auszubilden, daß zwei verschiedene zeitdiskrete Nutzsignalbearbeitungsverfahren gleichzeitig ohne störende Beeinflussungen in dem Hörgerät vorteilhaft anwendbar sind.

Diese Aufgabe wird durch ein Hörgerät mit den Merkmalen gemäß Anspruch 1 gelöst.

Ein wesentlicher Vorteil der Erfindung ist, daß das Abtastsignal für die erste zeitdiskrete Nutzsignalbearbeitung, z.B. mittels Pulscodemodulation, und das Dreiecksignal für die zweite zeitdiskrete Nutzsignalbearbeitung mit einer Pulsdauermodulation aus nur einem Oszillator abgeleitet sind. Dadurch entfallen die Intermodulationsprodukte, die durch die gleichzeitige Verwendung von gesonderten Oszillatoren für das Abtastsignal und für das Dreiecksignal entstehen würden.

Des weiteren wird trotz der Kombination von Mitteln für die Verwendung von zwei unterschiedlichen zeitdiskreten Nutzsignalverarbeitungsverfahren in nur einem Hörgerät der Platzbedarf durch die Einsparung eines Oszillators vermindert. Außerdem sind gegenseitige Abschirmungen, insbesondere zwischen den Hilfssignalen, entbehrlich, da sowohl das Abtastsignal als auch das Dreiecksignal aus dem gleichen Oszillator abgeleitet sind.

Es ist sonach insbesondere bezüglich der Frequenz eine starre Kopplung zwischen den beiden Hilfssignalen vorhanden, wodurch keine Synchronisationsprobleme entstehen können. Durch diese starre Kopplung arbeiten die beiden Hilfssignale selbst dann synchron, wenn eines der Hilfssignale in Weiterbildung der Erfindung vervielfacht wurde. Wenn die Grundfrequenz und die vervielfachte Frequenz so gewählt sind, daß deren Mischprodukte nicht in den Übertragungsbereich der Nutzsignale fallen, treten wegen der starren Kopplung zwischen diesen beiden Frequenzen keine Synchronisationsprobleme auf, die wiederum zu störenden Beeinflussungen führen könnten. Bei der Verwendung von getrennten Oszillatoren für die beiden voneinander verschiedenen zeitdiskreten Nutzsignalbearbeitungsverfahren müßte jeder Oszillator eine hohe Frequenzkonstanz aufweisen und/oder mit dem anderen synchronisiert sein, um das Entstehen von zusätzlichen Mischprodukten durch ein Auseinanderdriften der von zwei Oszillatoren erzeugten Frequenzen zu vermeiden.

Weitere Vorteile und Einzelheiten ergeben sich aus der nachfolgenden Beschreibung erfindungsgemäßer Ausführungsbeispiele anhand der Zeichnungen und in Verbindung mit den Ansprüchen.

Es zeigen:
Figur 1 ein Hörgerät für zwei verschiedene zeitdiskrete Nutzsignalbearbeitungsverfahren, dessen Komponenten von einem gemeinsamen Oszillator mit unterschiedlichen Hilfssignalen versorgt werden, und
Figur 2 in detaillierterer Darstellung einen Oszillator gemäß dem Hörgerät nach Figur 1.

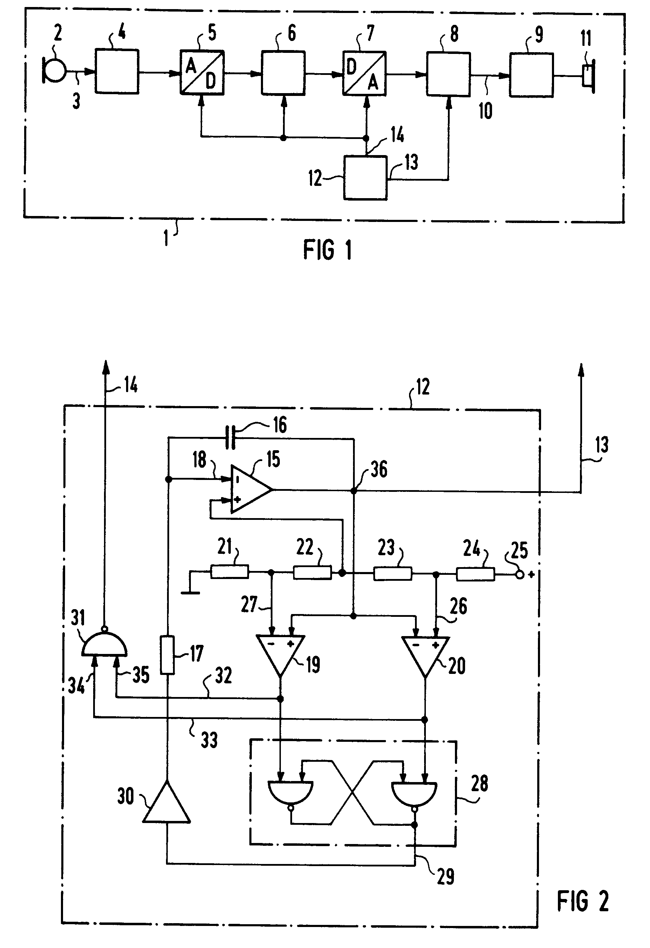

In Figur 1 ist durch eine strichpunktierte Linie ein Hörgerät 1 symbolisch dargestellt. Das Hörgerät 1 umfaßt als Eingangswandler ein Mikrofon 2, dessen elektrische Nutzsignale über eine Leitung 3 einer Nutzsignalbearbeitungseinrichtung zugeführt werden. Die Nutzsignalbearbeitungseinrichtung umfaßt in diesem Ausführungsbeispiel einen Vorverstärker 4, einen Analog-Digital-Wandler 5, eine erste zeitdiskrete Nutzsignalbearbeitungsstufe 6, einen Digital-Analog-Wandler 7, einen Modulator 8 zur Erzeugung eines pulsdauermodulierten Signals und eine Endstufe 9. Die Endstufe 9 ist als Schaltverstärker ausgebildet, der von dem pulsdauermodulierten Signal über eine Leitung 10 angesteuert wird. Die als Schaltverstärker ausgebildete Endstufe 9 stellt sonach eine Schaltung für eine zweite zeitdiskrete Signalbearbeitung dar, die von der zeitdiskreten Signalbearbeitung in der Nutzsignalbearbeitungsstufe 6 verschieden ist. Die Endstufe 9 ist mit einem elektrischen Hörer 11 als Ausgangswandler verbunden.

Das Hörgerät 1 weist erfindungsgemäß nur einen Oszillator 12 auf, der über seinen Ausgang 13 ein Dreiecksignal an den Modulator 8 und über seinen Ausgang 14 ein Abtastsignal an den Analog-Digital-Wandler 5, an die erste zeitdiskrete Signalbearbeitungsstufe 6 und an den Digital-Analog-Wandler 7 abgibt.

Der in Figur 1 enthaltene Oszillator 12 ist in Figur 2 als ein spezieller Oszillator 12 mit den Ausgängen 13 und 14 dargestellt. Der spezielle Oszillator 12 enthält als ein seine Frequenz bestimmendes Glied einen Integrator, der einen Operationsverstärker 15 mit einem Kondensator 16 und einem Widerstand 17 umfaßt. Durch den Kondensator 16 und den Widerstand 17 wird die Zeitkonstante des Integrators festgelegt. Der Operationsverstärker 15 ist durch den Kondensator 16 zwischen seinem Eingang 18 und seinem Ausgang 36 kapazitiv gegengekoppelt. Am Ausgang 36 des Operationsverstärkers 15 steht durch die Wirkung des Integrators ein Dreiecksignal zur Verfügung. Das Dreiecksignal wird einerseits dem Ausgang 13 des Oszillators 12 und andererseits einer Vergleichsschaltung mit zwei Komparatoren 19 und 20 zugeführt.

Der Oszillator 12 weist eine Reihenschaltung aus z.B. vier Widerständen 21 bis 24 auf. Die Reihenschaltung dieser Widerstände 21 bis 24 bildet einen Spannungsteiler, der über einen Anschluß 25 mit einer Betriebsspannungsquelle, z.B. mit dem Pluspol einer nicht dargestellten Hörgerätebatterie, verbindbar ist. Der Spannungsteiler liefert über eine Leitung 26 eine hohe und über eine Leitung 27 eine niedrige Schwellenspannung an die mit den beiden Komparatoren 19 und 20 gebildete Vergleichsschaltung. Das dieser Vergleichsschaltung zugeführte Dreiecksignal kann in der Amplitude (Scheitelwert) zwischen den Schwellenspannungen auf den beiden Leitungen 26 und 27 schwanken. Wenn die Amplitude des Dreiecksignals eine der Schwellenspannungen erreicht, gibt einer der Komparatoren 19 oder 20 ein Ausgangssignal an eine als Schaltmittel wirkende bistabile Kippstufe 28 ab. Dadurch ändert sich an einem Ausgang 29 der bistabilen Kippstufe 28 der Pegel von z.B. einem hohen Wert auf einen niedrigen Wert oder umgekehrt. Mit dem Ausgang 29 der bistabilen Kippstufe 18 ist über einen Treiber 30 und über den Widerstand 17 der Eingang 18 des Operationsverstärkers 15 verbunden.

Durch die Umschaltung des Ausgangspegels an der Kippstufe 28 ändert sich folglich auch der Pegel am Eingang 18 des Operationsverstärkers 15. Diese Pegeländerung bewirkt eine Umkehr der Integrationsrichtung des Integrators. Sobald durch die umgekehrte Integration wiederum eine Übereinstimmung mit einer der Schwellenspannungen auf den Leitungen 26 oder 27 erreicht wird, erfolgt eine erneute Umschaltung der bistabilen Kippstufe 28 durch ein Signal aus einem der beiden Komparatoren 19 oder 20. Dadurch wird die Integrationsrichtung des Integrators erneut umgekehrt. Die Anordnung schwingt folglich und bildet sonach einen Oszillator. Die Oszillatorfrequenz ist von der Zeitkonstante des Integrators 10 abhängig und wird auch noch durch die Wahl der Schwellenspannungen auf den Leitungen 26 und 27 beeinflußt.

Die bistabile Kippstufe 28 liefert ein Ausgangssignal, das auch als Abtastsignal verwendbar ist. Die bistabile Kippstufe 28 des Oszillators 12 stellt folglich auch einen Abtastsignalbildner dar.

In einer Variante der Erfindung kann das über den Ausgang 14 des Oszillators 12 entnehmbare Abtastsignal auch mittels einer Nicht-Und-Schaltung (NAND-Glied) 31 gebildet werden. Die Nicht-Und-Schaltung 31 ist sonach als ein Abtastsignalbildner ausgebildet. Dazu sind die Komparatoren 19 und 20 ausgangsseitig über Leitungen 32 und 33 mit zwei Eingängen 34 und 35 an dem Abtastsignalbildner 31 (NAND-Glied) verbunden. Durch die Ausbildung des Abtastsignalbildners als NAND-Glied 31 entsteht zugleich eine Frequenzverdoppelung des Abtastsignals gegenüber dem Dreiecksignal. Das NAND-Glied 31 wirkt sonach auch als Frequenzvervielfacher.

Die Grundfrequenz des Oszillators 12 ist so gewählt, daß in Verbindung mit der aus dem NAND-Glied 31 entnehmbaren doppelten Frequenz des Abtastsignals oder des Dreiecksignals keine Mischprodukte entstehen, die in den Übertragungsbereich der Nutzsignale fallen, die von dem Eingangswandler 2 aufgenommen und/oder von dem Ausgangswandler 11 abgegeben werden.

## Patentansprüche

1. Hörgerät mit einem Eingangswandler (2), einer eine Endstufe (9) aufweisenden Nutzsignalbearbeitungseinrichtung (4 bis 9) und mit einem Ausgangswandler (11), wobei vor der Endstufe (9) eine erste zeitdiskrete Nutzsignalbearbeitung vorgesehen ist, die durch ein Abtastsignal gesteuert ist, dadurch gekennzeichnet, dass in der Endstufe (9) eine zweite zeitdiskrete Nutzsignalbearbeitung mit einer Pulsdauermodulation vorgesehen ist, die durch ein Dreiecksignal gebildet ist und wobei zwischen dem Abtastsignal und dem Dreiecksignal bezüglich deren Frequenzen eine starre Kopplung vorhanden ist und diese Frequenzen aus nur einem Oszillator (12) abgeleitet sind.

2. Hörgerät nach Anspruch 1, wobei der Oszillator (12) als Dreieckspannungsgenerator ausgebildet ist, dessen Dreiecksignal in einer dem Oszillator (12) zugeordneten Vergleichsschaltung (19, 20) mit einer oberen und unteren Schwellenspannung vergleichbar ist, wobei im Falle einer Übereinstimmung des Dreiecksignals mit einer der Schwellenspannungen die Vergleichsschaltung (19, 20) ein Signal an einen Abtastsignalbildner (28, 31) abgibt.

3. Hörgerät nach Anspruch 1 oder 2, wobei der Oszillator (12) einen Integrator aufweist, dessen Integrationsrichtung in Abhängigkeit von einem Eingangssignal umkehrbar ist und der eingangsseitig mit einem Schaltmittel (28) und ausgangsseitig mit der Vergleichsschaltung (19, 20) in Wirkverbindung steht, wobei die Vergleichsschaltung (19, 20) das Schaltmittel (28) steuert, durch welches dem Integrator das Eingangssignal zur Umkehr der Integrationsrichtung an seinem Integratorausgang (36) zuführbar ist.

4. Hörgerät nach Anspruch 3, wobei an dem Integratorausgang (36) das Dreiecksignal und an einem Ausgang (29) des Schaltmittels (28) das Abtastsignal entnehmbar ist.

5. Hörgerät nach einem der Ansprüche 1 bis 4, wobei das Abtastsignal und das Dreiecksignal eine Frequenz aufweisen, die der von dem Oszillator (12) erzeugten Frequenz entspricht.

6. Hörgerät nach einem der Ansprüche 1 bis 4, wobei das Abtastsignal oder das Dreiecksignal eine Frequenz aufweist, die ein Vielfaches der von dem Oszillator (12) erzeugten Frequenz ist und aus einem dem Oszillator (12) zugeordneten Frequenzvervielfacher (31) entnehmbar ist.

7. Hörgerät nach einem der Ansprüche 1 bis 6, wobei die Frequenz des Oszillators (12) so gewählt ist, daß in Verbindung mit einer daraus abgeleiteten vielfachen Frequenz des Abtastsignals oder des Dreiecksignals keine Mischprodukte entstehen, die in den Übertragungsbereich der Nutzsignale fallen.

## Claims

1. Hearing aid having an input transducer (2), a useful-signal processing device (4 to 9) having an output stage (9), and having an output transducer (11), wherein provided upstream of the output stage (9) is a first discrete-time useful-signal processing which is controlled by a sampled signal, characterised in that provided in the output stage (9) is a second discrete-time useful-signal processing with a pulse-duration modulation that is formed by a delta signal and wherein there is a fixed link between the sampled signal and the delta signal with respect to the frequencies thereof and these frequencies are derived from only one oscillator (12).

2. Hearing aid according to claim 1, wherein the oscillator (12) is constructed as a delta-voltage generator (12), the delta signal of which can be compared, in a comparator circuit (19, 20) assigned to the oscillator, with an upper and lower threshold voltage, wherein in the case of an agreement of the delta signal with one of the threshold voltages, the comparator circuit (19, 20) outputs a signal to a sampled-signal generator (28, 31).

3. Hearing aid according to claim 1 or 2, wherein the oscillator (12) has an integrator, the integration direction of which is reversible as a function of an input signal and which integrator is operatively connected, on the input side, to a switching means (28) and, on the output side, to the comparator circuit (19, 20), wherein the comparator circuit (19, 20) controls the switching means (28), by means of which there can be supplied to the integrator output (36) of the integrator the input signal for reversing the integration direction.

4. Hearing aid according to claim 3, wherein the delta signal can be taken at the integrator output (36) and the sampled signal can be taken at an output (29) of the switching means (28).

5. Hearing aid according to one of claims 1 to 3, wherein the sampled signal and the delta signal have a frequency which corresponds to the frequency generated by the oscillator (12).

6. Hearing aid according to one of claims 1 to 4, wherein the sampled signal or the delta signal has a frequency which is a multiple of the frequency generated by the oscillator (12) and can be taken from a frequency multiplier (31) assigned to the oscillator (12).

7. Hearing aid according to one of claims 1 to 6, wherein the frequency of the oscillator (12) is selected in such a way that in connection with a multiple frequency of the sampled signal or of the delta signal that is derived therefrom, no mixed products which fall into the transmission range of the useful signals result.

## Revendications

1. Prothèse auditive comprenant un transducteur (2) d'entrée, un dispositif (4 à 9) de traitement du signal utile comportant un étage (9) d'extrémité et un transducteur (11) de sortie, un premier traitement de signal utile discret dans le temps étant prévu avant l'étage (9) d'extrémité et étant commandé par un signal de balayage, caractérisée en ce qu'il est prévu dans l'étage (9) d'extrémité un deuxième traitement du signal utile discret dans le temps, ayant une modulation en durée d'impulsions qui est formée par un signal triangulaire, et entre le signal de balayage et le signal triangulaire il y a en ce qui concerne leur fréquence, un couplage fixe et ces fréquences ne dérivent que d'un oscillateur (12).

2. Prothèse auditive suivant la revendication 1, dans laquelle l'oscillateur (12) est constitué sous la forme d'un générateur de tension triangulaire, dont le signal triangulaire peut être comparé dans un circuit (19, 20) comparateur associé à l'oscillateur (12), à une tension de seuil supérieure et inférieure, le circuit (19, 20) de comparaison envoyant un signal à un générateur (28, 31) de signal de balayage lorsque le signal triangulaire coïncide avec l'une des tensions de seuil.

3. Prothèse auditive suivant la revendication 1 ou 2, dans laquelle l'oscillateur (12) comporte un intégrateur dont la direction d'intégration peut être inversée en fonction d'un signal d'entrée, et qui coopère du côté de l'entrée avec un moyen (28) de commutation et du côté de la sortie avec le circuit (19, 20) comparateur, le circuit (19, 20) comparateur commandant le moyen (28) de commutation par lequel le signal d'entrée peut être envoyé à l'intégrateur pour inverser la direction d'intégration sur sa sortie (39) d'intégrateur.

4. Prothèse auditive suivant la revendication 3, dans laquelle le signal triangulaire peut être prélevé de la sortie (36) de l'intégrateur et le signal de balayage sur une sortie (29) du moyen (28) de commutation.

5. Prothèse auditive suivant l'une des revendications 1 à 4, dans laquelle le signal de balayage et le signal triangulaire ont une fréquence qui correspond à la fréquence produite par l'oscillateur (12).

6. Prothèse auditive suivant l'une des revendications 1 à 4, dans laquelle le signal de balayage ou le signal triangulaire ont une fréquence qui est un multiple de la fréquence produite par l'oscillateur (12) et qui peut être prélevée d'un multiplicateur (31) de fréquence associé à l'oscillateur (12).

7. Prothèse auditive suivant l'une des revendications 1 à 6, dans laquelle la fréquence de l'oscillateur (12) est choisie de façon à ne pas produire en liaison avec une fréquence multipliée qui en dérive du signal de balayage ou du signal triangulaire, de produits mixtes qui tombent dans le domaine de transmission des signaux utiles.
